# EUROPEAN PATENT APPLICATION

(11) **EP 4 600 994 A1**
(43) Date of publication of application: **13.08.2025**
(21) Application number: 23874588.9
(22) Date of filing: 05.09.2023
(51) Int. Cl.: H01L 21/3065

(54) **MULTILAYER STRUCTURE AND METHOD FOR PRODUCING MULTILAYER STRUCTURE**

(30) Priority: 05.10.2022 JP 2022160970
(71) Applicant: NHK Spring Co., Ltd., Yokohama-shi, Kanagawa 236-0004 (JP)
(72) Inventor: OTSUKA, Yusuke, Yokohama-shi, Kanagawa 236-0004 (JP); KANEDA, Noriyoshi, Yokohama-shi, Kanagawa 236-0004 (JP); SANO, Takamichi, Yokohama-shi, Kanagawa 236-0004 (JP)
(74) Representative: dompatent von Kreisler Selting Werner - Partnerschaft von Patent- und Rechtsanwälten mbB
(86) International application number: PCT/JP2023/032346
(87) International publication number: WO 2024/075459

(57) **Abstract**

A laminated structure includes a substrate having a first surface and a second surface provided continuously with the first surface, a first insulating film on the first surface and the second surface, and a second insulating film on the first insulating film and on a corner portion formed at a boundary between the first surface and the second surface, wherein a difference between a thermal expansion coefficient of the substrate and a thermal expansion coefficient of the second insulating film is smaller than the difference between the thermal expansion coefficient of the substrate and the thermal expansion coefficient of the first insulating film. A manufacturing method for a laminated structure includes using a substrate having a first surface and a second surface provided continuously with the first surface, forming a first insulating film on the first surface and the second surface, and forming a second insulating film by melting and spraying an organic material on the first insulating film and in a gap of the first insulating film.

## Description

### TECHNICAL FIELD

Embodiments of the present invention relate to a multilayer (laminated) structure and a manufacturing method for the laminated structure, and, for example, to a laminated structure for mounting a substrate and a manufacturing method for the laminated structure.

### BACKGROUND ART

A semiconductor device is mounted in almost all electronic devices and plays an important role in the functions of electronic devices. A semiconductor device is a device that utilizes semiconductor characteristics of silicon and the like. The semiconductor device is formed by laminating a semiconductor film, an insulating film, and a conductive film on a substrate, and patterning these films. The films are laminated using a vapor deposition method, a sputtering method, a chemical vapor deposition (CVD) method, a chemical reaction of the substrate, or the like, and the films are patterned by a lithography process. The lithographic process includes the formation of a resist mask by the formation of a resist on these films that are subjected to patterning, the exposure of the resist, and development, the partial removal of these films by etching, and the removal of the resist mask.

Characteristics of the film described above are greatly affected by conditions under which the film is formed or conditions under which the film is etched. One of the conditions is a voltage applied to a mounting table (hereinafter referred to as a "stage") for mounting a substrate. With recent miniaturization of a semiconductor device, a ratio (aspect ratio) between a diameter of a hole to be processed and a thickness of a film to be processed is increasing. Therefore, for example, a voltage applied to a stage included in the etching device tends to increase. In addition, as the voltage applied to the stage increases, a withstand voltage of a member included in the stage needs to be improved. Examples of the member included in the stage include a cold plate and an electrostatic chuck. Patent Literature 1 and Patent Literature 2 disclose a stage in which an insulating film is formed on a surface of the substrate by ceramic thermal spraying, which is one type of thermal spraying methods, and the withstand voltage of the insulating film is improved. In addition, it is known that an anodization method is used as another method for forming an insulating film on a surface of the stage.

### CITATION LIST

### PATENT LITERATURE

Patent Literature 1: Japanese Patent No. 6027407
Patent Literature 2: Japanese Utility model No. 2600558

### SUMMARY OF INVENTION

### TECHNICAL PROBLEM

According to the conventional method, it is difficult to form an insulating film at a boundary between one surface and another surface (hereinafter, also referred to as a corner portion or a corner), and in particular, there was a problem that a gap or a void was formed in the corner portion. In addition, there was a problem that a gap was generated when the insulating film was heated. When a gap or an air gap is generated, the withstand voltage of the insulating film (also referred to as a breakdown voltage) decreases.

Therefore, an object of the present invention is to provide a laminated structure having excellent insulating performance and reliability.

### SOLUTION TO PROBLEM

According to an embodiment of the present invention, a laminated structure is provided including a substrate having a first surface and a second surface provided continuously with the first surface, a first insulating film on the first surface and the second surface, and a second insulating film on the first insulating film and on a corner portion formed at a boundary between the first surface and the second surface, wherein a difference between a thermal expansion coefficient of the substrate and a thermal expansion coefficient of the second insulating film is smaller than the difference between the thermal expansion coefficient of the substrate and the thermal expansion coefficient of the first insulating film.

In the laminated structure, a thickness of the second insulating film is greater than a thickness of the first insulating film at the corner portion formed at the boundary between the first surface and the second surface.

According to an embodiment of the present invention, a laminated structure is provided including a substrate having a first surface, a first insulating film provided on a first region of the first surface of the substrate, and a second insulating film provided on the first insulating film in the first region of the first surface of the substrate, and provided on a second region adjacent to the first region, wherein a difference between a thermal expansion coefficient of the substrate and a thermal expansion coefficient of the second insulating film is smaller than the difference between the thermal expansion coefficient of the substrate and the thermal expansion coefficient of the first insulating film.

The laminated structure may further include a gap existing between the substrate and the second insulating film in the second region.

In the laminated structure, the substrate may be a metal, and the first insulating film may be a metal oxide.

In the laminated structure, a thickness of the second insulating film on the first surface may be greater than the thickness on the second surface.

In the laminated structure, the substrate may be aluminum, and the first insulating film may be aluminum oxide.

In the laminated structure, the second insulating film may include an organic material.

In the laminated structure, the second insulating film may include polybenzimidazole.

According to an embodiment of the present invention, a manufacturing method is provided for a laminated structure including using a substrate having a first surface and a second surface provided continuously with the first surface, forming a first insulating film on the first surface and the second surface, and forming a second insulating film by melting and spraying an organic material on the first insulating film and in a gap of the first insulating film.

In the manufacturing method for the laminated structure, the substrate is a metal, and the first insulating film may be formed by anodic oxidation.

In the manufacturing method for the laminated structure, the first insulating film may be formed by thermal spraying.

In the manufacturing method for the laminated structure, the first insulating film may be a metal oxide.

In the manufacturing method for the laminated structure, a thickness of the second insulating film may be greater than a thickness of the first insulating film at a corner portion formed by the first surface and the second surface.

In the manufacturing method for the laminated structure, the second insulating film may include a resin material.

In the manufacturing method for the laminated structure, the second insulating film may include polybenzimidazole.

The manufacturing method for the laminated structure may include heating the first insulating film after forming the first insulating film along the first surface and the second surface.

### ADVANTAGEOUS EFFECT OF INVENTION

According to an embodiment of the present invention, a laminated structure having excellent insulating performance and reliability can be provided.

### BRIEF DESCRIPTION OF DRAWINGS

FIG. 1A is a schematic perspective view of a laminated structure according to an embodiment of the present invention.
FIG. 1B is a schematic perspective view of a laminated structure according to an embodiment of the present invention.
FIG. 2A is an enlarged cross-sectional view of a part of a laminated structure according to an embodiment of the present invention.
FIG. 2B is an enlarged cross-sectional view of a part of a laminated structure according to an embodiment of the present invention.
FIG. 3 is a flow chart showing a manufacturing method for a laminated structure according to an embodiment of the present invention.
FIG. 4A is a schematic cross-sectional view showing a manufacturing method for a laminated structure according to an embodiment of the present invention.
FIG. 4B is a schematic cross-sectional view showing a manufacturing method for a laminated structure according to an embodiment of the present invention.
FIG. 5A is a schematic cross-sectional view showing a manufacturing method for a laminated structure according to an embodiment of the present invention.
FIG. 5B is a schematic cross-sectional view showing a manufacturing method for a laminated structure according to an embodiment of the present invention.
FIG. 6 is a schematic cross-sectional view of a film processing device including a laminated structure according to an embodiment of the present invention.
FIG. 7A is a schematic diagram showing cross-sectional SEM observation points of a laminated structure according to an embodiment of the present example.
FIG. 7B is a cross-sectional SEM observation result of a laminated structure according to the present example.
FIG. 7C is a cross-sectional SEM observation result of a laminated structure according to the present example.
FIG. 7D is a cross-sectional SEM observation result of a laminated structure according to the present example.
FIG. 8 shows the results of a hydrochloric acid bubble test according to the present example.
FIG. 9 shows the results of the breakdown voltage point measurement according to the present example.
FIG. 10 shows the results of the overall breakdown voltage measurement according to the present example.

### DESCRIPTION OF EMBODIMENTS

Hereinafter, each embodiment of the present invention will be described with reference to the drawings. However, the present invention can be implemented in various forms without departing from the gist thereof, and should not be construed as being limited to the description of the following exemplary embodiments.

Furthermore, in the drawings referred to in the present embodiment, the same portions or similar functions are denoted by the same reference signs or similar reference signs (reference signs denoted by - (hyphen) numerals or the like after the reference signs), and repetitive description thereof may be omitted. In addition, for the convenience of description, the dimensional ratio of the drawings may be different from the actual ratio, or a part of the configuration may be omitted from the drawings.

### [First Embodiment]

A configuration of a laminated structure 10 and a manufacturing method for the laminated structure 10 according to the present embodiment will be described.

### [1-1. Configuration of Laminated Structure 10]

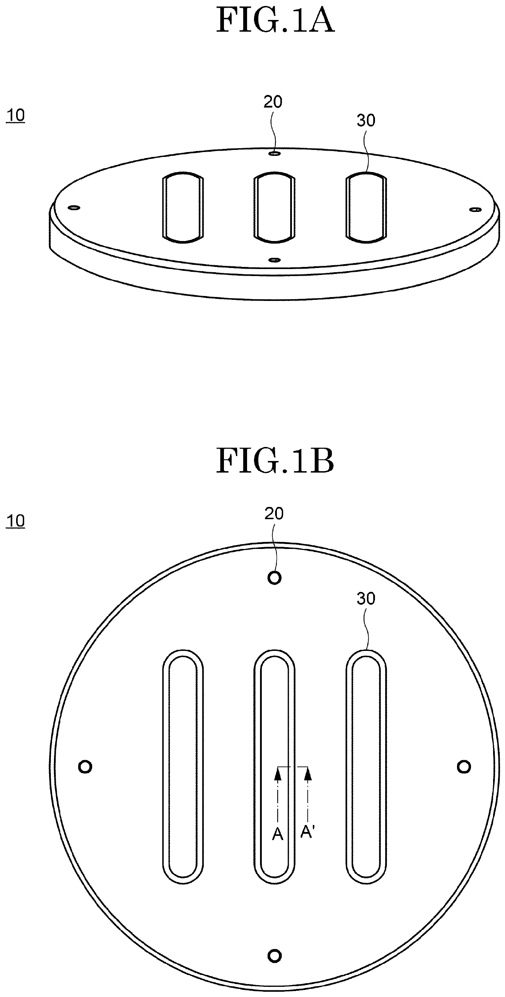

FIG. 1A and 1B are a schematic perspective view and a plan view of the laminated structure 10 according to an embodiment of the present invention. Specifically, FIG. 1A is a schematic perspective view of the laminated structure 10. FIG. 1B is a schematic plan view of the laminated structure 10.

The laminated structure 10 is disc-shaped. The laminated structure 10 has an upper surface on which a substrate (for example, a silicon wafer) can be placed, and can be used as a stage. For example, the laminated structure 10 has a diameter large enough to place a 12-inch silicon wafer. A hole 20 for a lift pin for lifting the substrate and a groove 30 for flowing a gas used in manufacturing the semiconductor device are arranged in the laminated structure 10. The arrangement, numbers, and shapes of the hole 20 and the groove 30 may be appropriately changed according to the specifications of the semiconductor device manufacturing device.

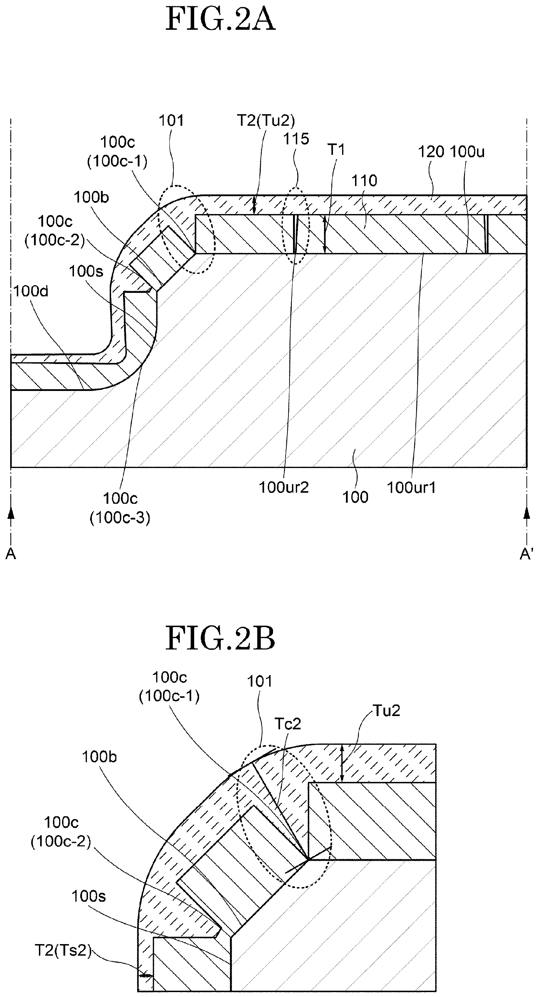

FIG. 2A is a schematic cross-sectional view of the groove 30 of the laminated structure 10 cut along a line A-A' shown in FIG. 1B. FIG. 2B is an enlarged cross-sectional view of a part of FIG. 2A. The laminated structure 10 includes a substrate 100, a first insulating film 110, and a second insulating film 120. The first insulating film 110 is arranged so as to cover an upper surface 100u (also referred to as a first surface), a side surface 100s, and a bottom surface 100d of the substrate 100. Furthermore, in the present embodiment, a chamfered portion 100b (also referred to as a second surface) is arranged between the upper surface 100u and the side surface 100s of the substrate 100. The chamfered portion 100b is arranged continuously to the upper surface 100u and is arranged continuously to the side surface 100s. In the present example, the chamfered portion 100b is a C-chamfer. For example, the dimension of the chamfered portion 100b is 0.1 mm or more and 10 mm or less. The chamfered portion 100b is similarly arranged in the hole 20 and at an end portion of the substrate 100.

For example, a metal can be used as a material of the substrate 100. In the present embodiment, aluminum (Al) is used as the substrate 100.

A material capable of satisfying desired withstand voltage characteristics is used as the first insulating film 110. An inorganic insulating material such as a metal oxide is used as the first insulating film 110. In the present example, aluminum oxide (Al2O3), which is a metal oxide is used as the first insulating film 110, in accordance with the metal (aluminum) used as the substrate 100.

A thickness Tu1 of the first insulating film 110 on the upper surface 100u is preferably 5 µm or more and 100 µm or less from the viewpoint of the withstand voltage characteristics.

The second insulating film 120 is arranged on the first insulating film 110 and on a corner portion 100c formed at the boundary between the adjacent surfaces of the substrate 100. The difference between a thermal expansion coefficient of the substrate 100 and a thermal expansion coefficient of the second insulating film 120 is smaller than the difference between the thermal expansion coefficient of the substrate 100 and the thermal expansion coefficient of the first insulating film 110. For this reason, a material that is close to the thermal expansion coefficient of the substrate 100 and highly corrosion-resistant and heat-resistant is used as the second insulating film 120. In the present example, a resin material is used as the second insulating film 120. More specifically, the second insulating film 120 contains polybenzimidazole (PBI). Polybenzimidazole has excellent corrosion resistance and heat resistance and has a characteristic that the thermal expansion coefficient is close to the thermal expansion coefficient of aluminum.

A thickness Tu2 of the second insulating film on the upper surface 100u is preferably 5 µm or more and 100 µm or less, and more preferably 10 µm or more and 50 µm or less from the viewpoint of the withstand voltage characteristics.

In the laminated structure 10 according to the present embodiment, in a boundary region 101 (the corner portion 100c) formed between the upper surface 100u (first surface) and the chamfered portion 100b (second surface), a thickness Tc2 of the second insulating film 120 is greater than the thickness T1 of the first insulating film 110. In this case, the thickness Tc2 of the second insulating film 120 on a corner portion 100c-1 has a thickness equal to or greater than the thickness T1 of the first insulating film 110 on the upper surface 110u. The thickness of the second insulating film 120 is greater than the thickness of the first insulating film 100 also on the corner portion 100c (a corner portion 100c-2) between the chamfered portion 100b and the side surface 100s and on the corner portion 100c (a corner portion 100c-3) between the side surface 100s and the bottom surface 100d.

Furthermore, in the present embodiment, in addition to the corner portion 100c, the second insulating film 120 is arranged in a region (second region 100ur2) in which a crack 115 (gap) is generated in the first insulating film 110 and a region (first region 100ur1) in which the crack 115 (gap) is not present within the upper surface 100u of the substrate 100. The first insulating film 110 and the second insulating film 120 are laminated on the first region 100ur1. A gap (space) may be arranged between the substrate 100 and the second insulating film 120 on the second region 100ur2, or all or a part of the second insulating film 120 may be filled in the crack 115. The second insulating film 120 has an equivalent thickness in the first region 100ur1 and the second region 100ur2. In addition, the crack 115 is arranged between the first insulating film 110. Therefore, the above-described second region 100ur2 may be said to be adjacent to the first region 100ur1.

As described above, the polybenzimidazole has excellent corrosion resistance and heat resistance, and has a characteristic that the thermal expansion coefficient is close to the thermal expansion coefficient of aluminum. As a result, in the case where the high-temperature heat treatment is repeatedly performed on the laminated structure, the second insulating film can follow the thermal expansion of the substrate and the first insulating film. Therefore, even when the crack 115 occurs in the first insulating film 110, since the second insulating film is present, the substrate 100 is suppressed from being exposed. In addition, in the case of the present embodiment, the entire surface of the substrate 100 is covered with the first insulating film 110 or the second insulating film 120 having a predetermined thickness or more. This improves the withstand voltage of the laminated structure 10. Therefore, the laminated structure 10 according to the present embodiment can be said to have excellent insulating performance and reliability.

Furthermore, in the present embodiment, the thickness Ts2 of the second insulating film 120 on the side surface 100s may be smaller than the thickness Tu2 of the second insulating film 120 on the upper surface 100u.

### [1-2. Manufacturing method for Laminated Structure 10)

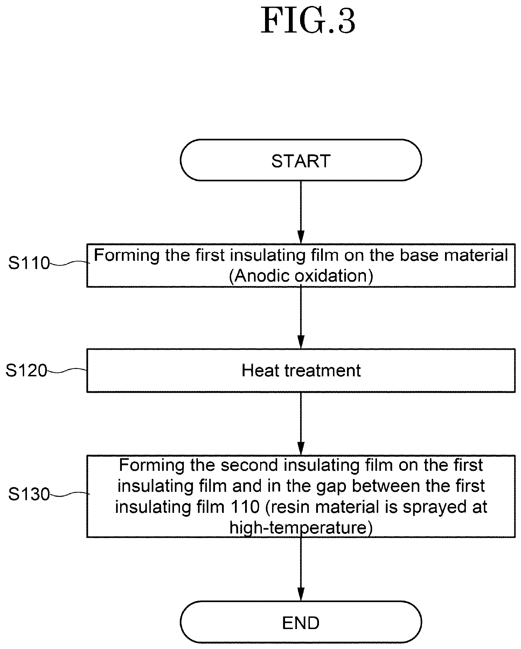

Next, a manufacturing method for the laminated structure 10 according to the present embodiment will be described with reference to FIG. 3 to FIG. 5.

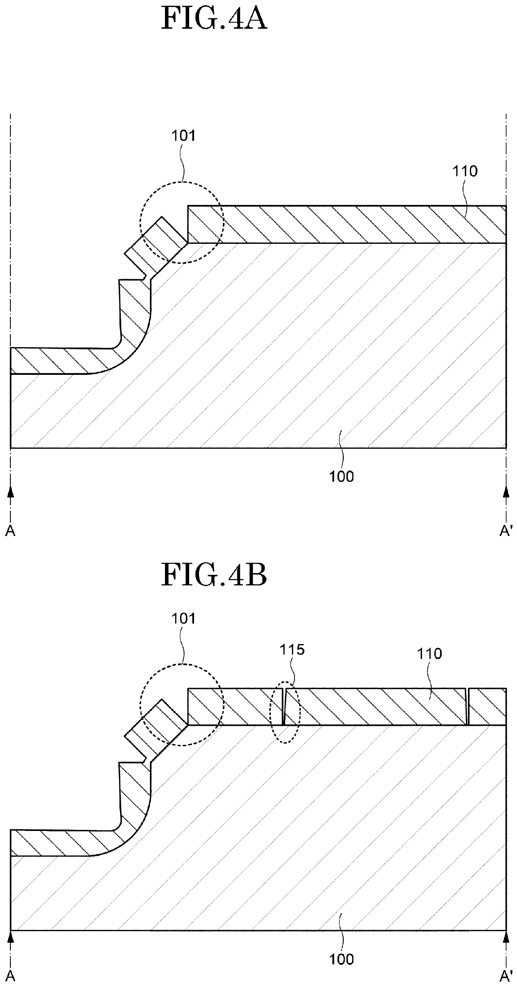

FIG. 3 is a flowchart showing a manufacturing method for the laminated structure 10 according to the present embodiment. FIG. 4 to FIG. 5 are schematic cross-sectional views showing the method for manufacturing the laminated structure 10 according to the present embodiment.

First, as shown in FIG. 3 and FIG. 4A, the first insulating film 110 is formed on the prepared substrate 100 (step S110). In the present example, an aluminum substrate is used as the substrate 100. The aluminum oxide as the first insulating film 110 is formed by anodizing the aluminum substrate. In this case, from the viewpoint of improving the withstand voltage, the thickness of the aluminum oxide is preferably 5 µm or more and 100 µm or less, and preferably 10 µm or more and 50 µm or less. In the case of anodization, the first insulating film can be formed thicker at a lower cost than by the other processing methods.

Next, as shown in FIG. 3 and FIG. 4B, the substrate 100 and the first insulating film 110 are subjected to a heat treatment (step S120). The heat treatment is preferably 100°C or higher and 500°C or lower from the viewpoint of generating the crack in the first insulating film 110. By performing the heat treatment with the above-described temperature range, the crack 115 can be generated, and the gap can be generated in the first insulating film 110 in advance.

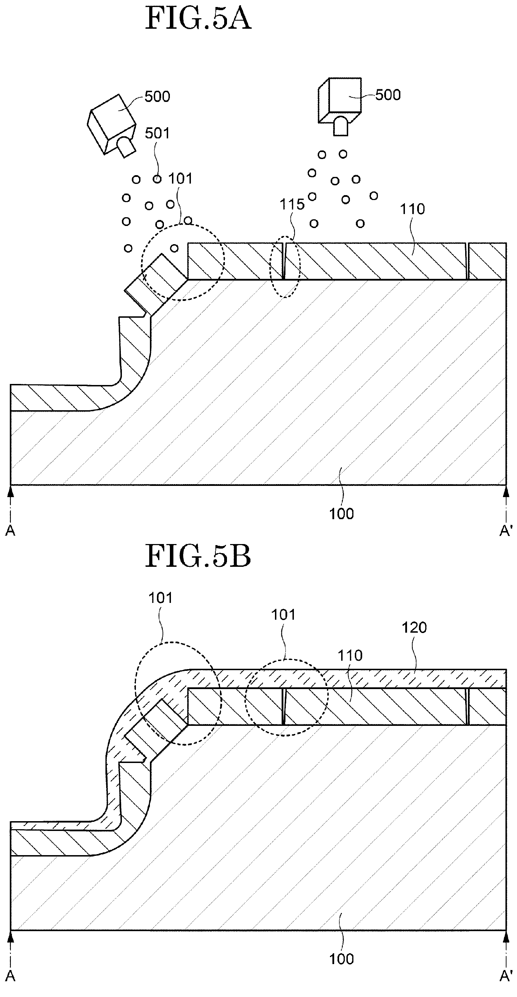

Next, as shown in FIG. 3 and FIG. 5A, the second insulating film is formed on the first insulating film 110 and the crack 115 of the first insulating film 110 (step S130). Specifically, the second insulating film 120 is formed by melting a resin material 501 (specifically, polybenzimidazole) at a high temperature and spraying (high-temperature spraying) from a spraying device 500 to the surface of the first insulating film 110 and the crack 115 (gap) of the first insulating film 110. **In** the high-temperature spraying treatment in this case, polybenzimidazole heated to 400°C or higher is sprayed in consideration of the glass transition point. In this case, from the viewpoint of the withstand voltage, the thickness of the polybenzimidazole is preferably 5 µm or more and 100 µm or less, and preferably 10 µm or more and 50 µm or less. In the high-temperature spraying treatment, a dense insulating film can be formed by curing the molten resin material to form a film.

The high-temperature spraying treatment is performed from the upper surface 100u side of the substrate 100. Therefore, the second insulating film 120 can be deposited substantially uniformly on the upper surface 100u of the substrate 100 and the chamfered portion 100b of the substrate 100. In addition, it may be difficult to deposit the second insulating film 120 on the side surface 100s of the substrate 100 as compared with the upper surface 100u of the substrate 100. Therefore, the thickness of the second insulating film 120 on the side surface 100s may be smaller than the thickness of the second insulating film 120 on the upper surface 100u. However, in the case of the present embodiment, since a thick first insulating film 110 can be formed y by the anodization treatment, the first insulating film 110 having a predetermined thickness can be stably formed on the side surface 100s of the substrate 100. As described above, the laminated structure 10 is manufactured as shown in FIG. 5B.

According to the manufacturing method for the laminated structure 10 according to the present embodiment, the thick first insulating film can be formed inexpensively by using anodization, and the second insulating film which is dense and close to the thermal expansion coefficient of the substrate is formed in the gap of the first insulating film by the high-temperature spraying treatment. As a result, the entire surface of the substrate 100 is covered with the first insulating film 110 or the second insulating film 120 having a predetermined thickness or more. Therefore, even if the heat treatment is repeated, defects in the insulating film of the laminated structure 10 are eliminated, and the withstand voltage is improved. Therefore, by using the present embodiment, the laminated structure 10 having excellent insulating performance and reliability can be manufactured.

In addition, the chamfered portion 100b arranged on the substrate 100 has been mainly described in the present embodiment, but the second insulating film 120 is similarly formed in the lift pin hole 20, and on the chamfered portion in the end portion of the substrate.

Furthermore, in the present embodiment, a thick aluminum oxide may be formed, and the polybenzimidazole may be formed thinner than the aluminum oxide. This makes it possible to reduce the manufacturing cost of the laminated structure.

### [Second Embodiment]

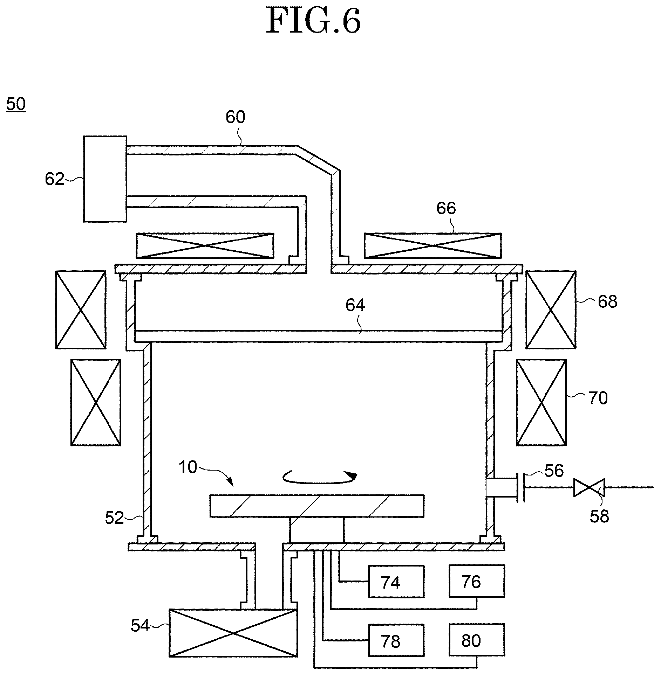

A configuration of a film processing device 50 according to an embodiment of the present invention will be described with reference to FIG. 6. The film processing device 50 includes the laminated structure 10. Therefore, the description of the configuration of the laminated structure 10 according to the first embodiment may be omitted.

FIG. 6 is a schematic cross-sectional view of the film processing device 50 according to an embodiment of the present invention. The film processing device 50 is a so-called etching device, but the film processing device 50 is not limited to this.

The film processing device 50 can perform the dry etching on various films. The film processing device 50 includes a chamber 52. The chamber 52 provides a space for etching a film such as a conductor, an insulator, or a semiconductor formed on the substrate.

An exhaust device 54 is connected to the chamber 52, so that the inside of the chamber 52 can be set to a reduced-pressure atmosphere. An introduction pipe 56 for introducing a reaction gas is further arranged in the chamber 52, and the reaction gas for etching is introduced into the chamber via a valve 58. Examples of the reactive gas includes a fluorine-containing organic compound such as carbon tetrafluoride (CF4), octafluorocyclobutane (c-C4F8), decafluorocyclopentane (c-C5F10), or hexafluorobutadiene (C4F6).

A microwave source 62 may be arranged at the top of the chamber 52 via a waveguide 60. The microwave source 62 includes an antenna or the like for supplying microwaves, and outputs high-frequency microwaves such as 2.45 GHz microwaves or 13.56 MHz radio waves (RF). The microwave generated by the microwave source 62 is propagated to the top of the chamber 52 by the waveguide 60, and is introduced into the chamber 52 via a window 64 containing quartz, ceramic, or the like. The reaction gas is converted into plasma by the microwaves, and the etching of the film proceeds due to the electrons, ions, and radicals contained in the plasma.

The laminated structure 10 for placing the substrate is arranged at the bottom of the chamber 52. A power source 74 is connected to the laminated structure 10, a voltage corresponding to the high-frequency power is applied to the laminated structure 10, and the electric field by the microwave is formed on the surface of the laminated structure 10 and in a direction perpendicular to the substrate surface. A magnet 66, a magnet 68, and a magnet 70 are further arranged on the top or side of the chamber 52. The magnet 66, the magnet 68, and the magnet 70 may be permanent magnets or electromagnets having electromagnetic coils. The magnet 66, the magnet 68, and the magnet 70 generate magnetic field components parallel to the laminated structure 10 and the substrate surface, and in conjunction with the electric field generated by the microwave, the electrons in the plasma resonate under the Lorentz force and are bound to the laminated structure 10 and the substrate surface. As a result, a plasma with high density can be generated on the substrate surface.

For example, in the case where the laminated structure 10 includes a sheath heater, a heater power source for controlling the sheath heater is connected. Furthermore, as an optional configuration, a power source 76 for an electrostatic chuck for fixing the substrate to the laminated structure 10, a temperature controller 78 for controlling the temperature of the medium circulated inside the laminated structure 10, and a rotation control device (not shown) for rotating the laminated structure 10 may be connected to the laminated structure 10.

The film processing device 50 according to the present embodiment includes the laminated structure 10. By using the laminated structure 10, the substrate can be uniformly heated, and the heating temperature can be precisely controlled. By using the laminated structure 10 having excellent insulating performance, the withstand voltage with respect to the voltage applied to the substrate is improved. Therefore, by using the film processing device 50, it is possible to form a contact having a high aspect ratio or a film having a high aspect ratio. Therefore, the film processing device 50 can uniformly etch various films arranged on the substrate. Furthermore, by using the laminated structure 10 having excellent reliability, the number of maintenances for the film processing device 50 can be reduced.

### [EXAMPLES]

In the present example, the laminated structure according to an embodiment of the present invention is manufactured and the results of various evaluations will be described.

### [1. Processing Conditions for Each Sample]

### [1-1. Processing Conditions of Example 1]

In the present example, the processing conditions for the sample in Example 1 are as follows.
Material of the substrate: A6061 (aluminum)
Size of the substrate: Φ118 mm × thickness 8 mm
First insulating film (aluminum oxide): 30 µm film deposited by the anodization treatment
Second insulating film: Polybenzimidazole is deposited to a thickness of 15 µm by high-temperature spraying treatment

### [1-2. Processing Conditions for Comparative Example 1]

In the present example, the processing conditions for the sample in Comparative Example 1 are as follows.
Material of the substrate: A6061 (aluminum)
Size of the substrate: Φ118 mm × thickness 8 mm
First insulating film (aluminum oxide): 30 µm film deposited by the anodization treatment

### [1-3. Processing Conditions for Comparative Example 2]

In the present example, the processing conditions for the sample in Comparative Example 2 are as follows.
Material of the substrate: A6061 (aluminum)
Size of the substrate: Φ118 mm × thickness 8 mm
Second insulating film: Polybenzimidazole is deposited to a thickness of 15 µm by the high-temperature spraying method

### [1-4. Temperature-Rising Cycle Processing]

In the present example, for each evaluation sample, a temperature-raising cycle was performed 30 times, in which the temperature was increased from room temperature to 375°C and held for 30 minutes, and then returned to room temperature.

### [2. Evaluation Results]

### [2-1. Observation and Evaluation of Cross-sectional SEM]

In the present example, the cross-sectional SEM observation was carried out on the sample in Example 1 after the above temperature-raising cycle treatment.

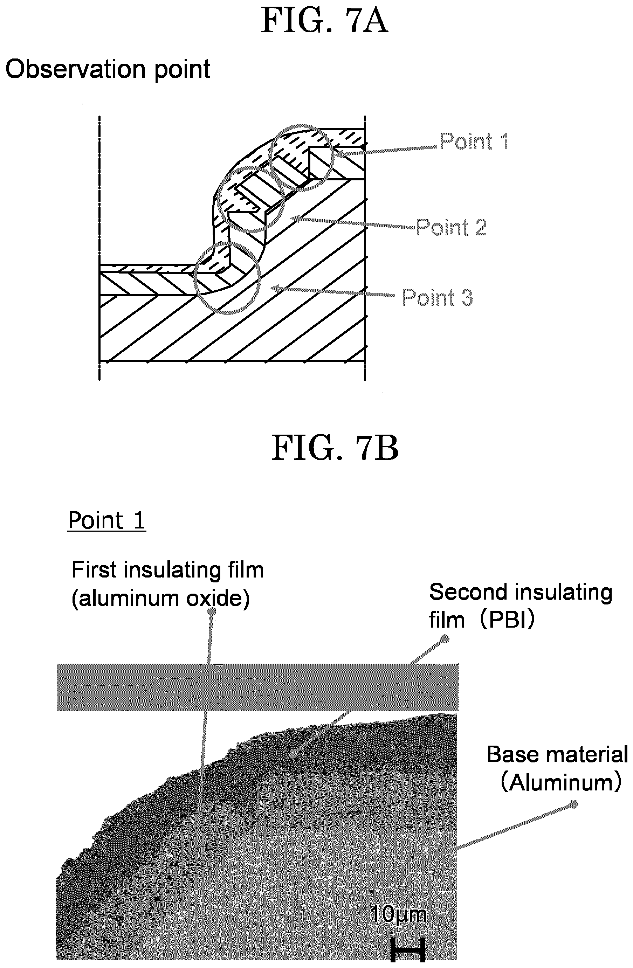

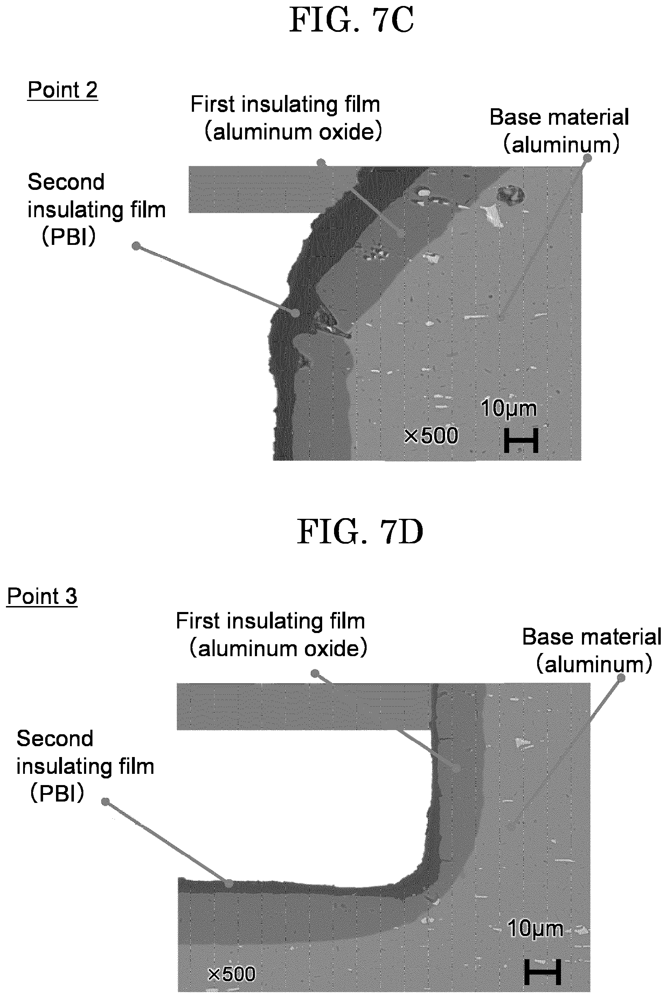

FIG. 7 is a cross-sectional SEM observation evaluation. More specifically, FIG. 7A is a schematic view showing cross-sectional SEM observation points. FIG. 7B is a cross-sectional SEM observation result at the observation point 1. FIG. 7C is a cross-sectional SEM observation result at the observation point 2. FIG. 7D is a cross-sectional SEM observation result at the observation point 3. As shown in FIG. 7B, FIG. 7C, and FIG. 7D, it can be recognized that the first insulating film (aluminum oxide) is uniformly formed on the upper surface, the chamfered portion, the side surface, and the bottom surface in Example 1. In addition, it can be recognized that the second insulating film is formed at the interface (corner portion) between the upper surface and the chamfered portion and at the interface (corner portion) between the side surface and the chamfered portion so as to cover the gap between the aluminum oxide. In other words, it can be said that the substrate is covered with the first insulating film or the second insulating film over the entire surface.

### [2-2. Hydrochloric Acid Bubble Test]

In the present example, the evaluation samples of Example 1 and Comparative Example 2 were held in a 5 wt% hydrochloric acid solution in an environment at a temperature of 25±5°C for a predetermined time after the temperature-raising cycle processing described above to evaluate the occurrence of bubbles due to corrosion.

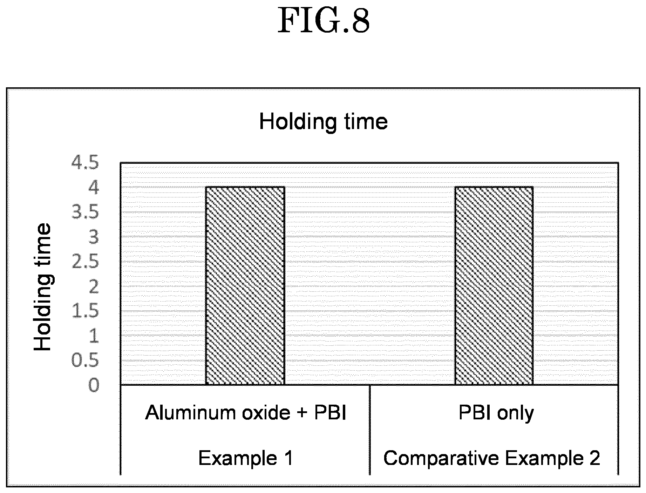

FIG. 8 is the test results of the hydrochloric acid bubble test. As shown in FIG. 8, in both the evaluation samples of Example 1 and Comparative Example 2, the occurrence of bubbles was not confirmed even when immersed in the hydrochloric acid solution for 4 hours or more. In other words, it can be confirmed that the substrate (aluminum) of the evaluation samples is protected by the second insulating film (PBI) without being exposed.

### [2-3. Breakdown Voltage Test]

In the present example, the insulating film was subjected to a breakdown voltage test after the temperature-raising cycle processing. In the breakdown voltage test, a point measurement was performed at a predetermined point of the test sample and an overall measurement was performed over the entire sample.

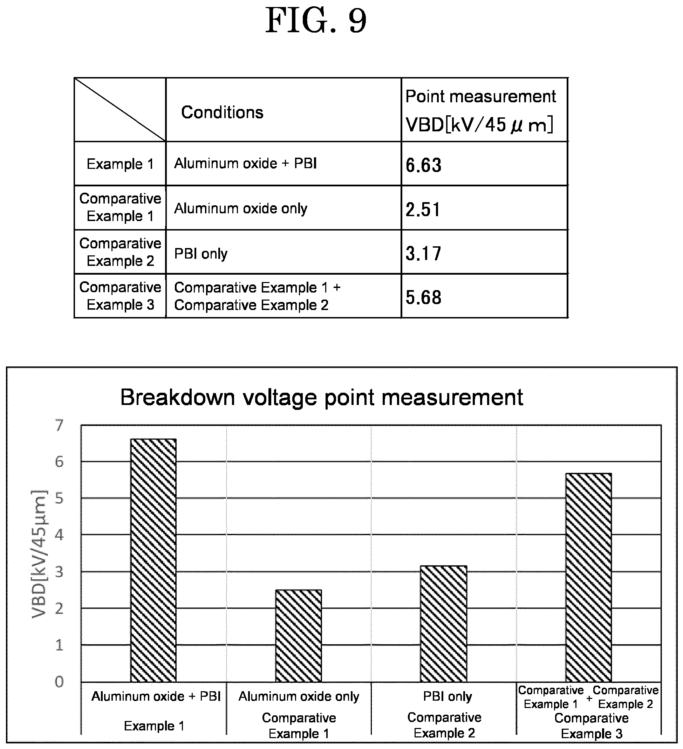

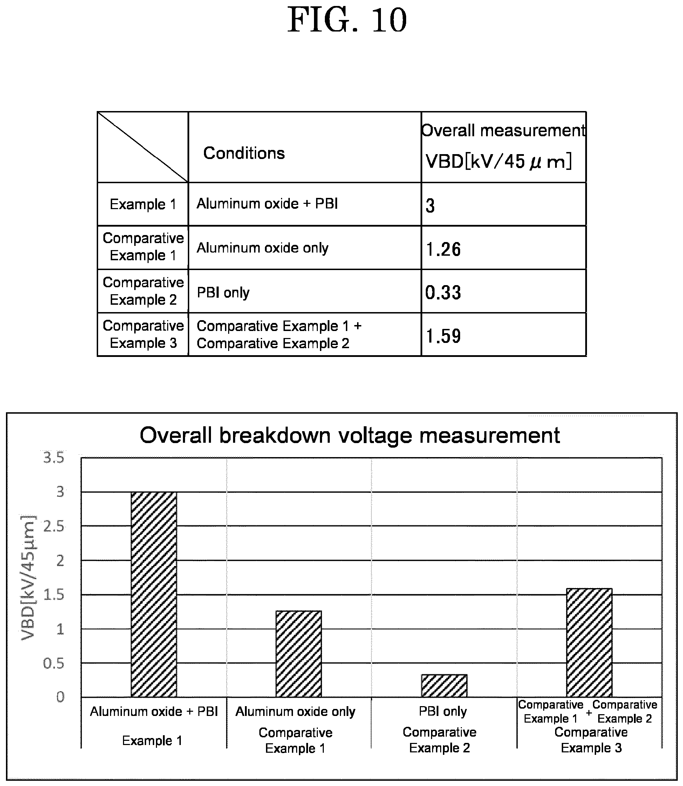

FIG. 9 is the results of the breakdown voltage point measurement. FIG. 10 is the results of the overall breakdown voltage measurement. As shown in FIG. 9 and FIG. 10, in both the breakdown voltage point measurement and the overall measurement, the breakdown voltage was confirmed to be improved in Example 1 as compared with Comparative Example 1 and Comparative Example 2. Furthermore, in the example, the breakdown voltage of Example 1 is higher than the result of Comparative Example 3 obtained by adding the results of Comparative Example 1 and Comparative Example 2. In other words, it was confirmed that the breakdown voltage was synergistically improved by combining the first insulating film (aluminum oxide) and the second insulating film (PBI) as compared with the case where each insulating film was used alone. Therefore, it is possible to provide a laminated structure having excellent insulating performance and reliability by using an embodiment of the present invention.

### [Modification]

Each of the embodiments described above as an embodiment of the present invention can be appropriately combined and implemented as long as no contradiction is caused. Furthermore, the addition, deletion, or design change of components as appropriate by those skilled in the art based on each embodiment are also included in the scope of the present invention as long as they are provided with the gist of the present invention.

Further, it is understood that, even if the effect is different from those provided by each of the above-described embodiments, the effect obvious from the description in the specification or easily predicted by persons ordinarily skilled in the art is apparently derived from the present invention.

Although the example in which the polybenzimidazole resin is used as the second insulating film 120 has been shown in the first embodiment of the present invention, the present invention is not limited to polybenzimidazole resin. For example, polyimide resin, polyetheriimide resin, polyamide-imide resin, polytetrafluoroethylene resin, polyetheretherketone resin, polyphenylene sulfide resin may be used as the insulating film.

Although the example in which a metal, in particular, aluminum, is used as a material of the substrate 100 has been shown in the first embodiment of the present invention, the present invention is not limited to aluminum. For example, the substrate 100 may be made of a metal other than aluminum, such as titanium (Ti) or stainless steel. In addition, ceramics may be used other than a metal.

Although the example in which aluminum oxide is used as the first insulating film 110 has been shown in the first embodiment of the present invention, the present invention is not limited to aluminum oxide. The first insulating film 110 may be an oxide containing at least one element selected from a group consisting of an alkaline earth metal, a rare earth metal, aluminum (Al), tantalum (Ta), titanium (Ti), chromium (Cr), zirconium (Zr), yttrium (Y), and silicon (Si), or a complex oxide thereof, in addition to aluminum oxide.

Although the example in which the first insulating film 110 is formed on the substrate 100 by anodizing has been shown in the first embodiment of the present invention, the present invention is not limited to this example. For example, the first insulating film 110 may be formed by subjecting the substrate 100 to a thermal spraying processing. In the case of the thermal spraying processing, different elements may be used for the substrate 100 and the first insulating film 110 (for example, the substrate may be glass, and the first insulating film may be aluminum oxide).

Although the example in which the second insulating film 120 is formed by performing the high-temperature spraying treatment of the organic material (resin material, more specifically, polybenzimidazole) has been shown in the first embodiment of the present invention, the present invention is not limited to this example. For example, the second insulating film 120 may be formed by immersing the substrate in a solution containing an organic resin. In this case, the second insulating film 120 may be formed and then subjected to heat treatment.

In addition, although the groove 30 has been mainly described in the first embodiment of the present invention, the hole 20 and the substrate may have the same configuration. Furthermore, a similar configuration may be arranged not only on the upper surface but also on the lower surface of the substrate.

Although the example in which the heat treatment is performed after the first insulating film is formed has been shown in the first embodiment of the present invention, the present invention is not limited to this example. The heat treatment may not be performed depending on the material of the first insulating film.

Although the example in which the laminated structure 10 is used for the stage has been shown in the first embodiment of the present invention, the present invention is not limited to this example. For example, the laminated structure 10 can be used as a heater or cold plate in the stage of the semiconductor manufacturing device. Alternatively, the laminated structure 10 may be used as a showerhead in a semiconductor manufacturing device upper electrode. The laminated structure may be used in a heated environment or may be used in a cooled environment, such as with liquid nitrogen.

### REFERENCE SIGNS LIST

10: laminated structure, 20: hole, 30: groove, 35: heater power source, 50: film processing device, 52: chamber, 54: exhaust device, 56: introduction pipe, 58: valve, 60: waveguide, 62: microwave source, 64: window, 66: magnet, 68: magnet, 70: magnet, 74: power source, 76: power source, 78: temperature controller, 100: substrate, 100b: chamfered portion, 100c: corner portion, 100d: bottom surface, 100e: edge, 100s: side surface, 103: bottom surface, 110: first insulating film, 115: crack, 120: second insulating film, 500: spraying device, 501: resin material

## Claims

1. A laminated structure comprising:
a substrate having a first surface and a second surface provided continuously with the first surface;
a first insulating film on the first surface and the second surface; and
a second insulating film on the first insulating film and on a corner portion formed at a boundary between the first surface and the second surface, wherein
a difference between a thermal expansion coefficient of the substrate and a thermal expansion coefficient of the second insulating film is smaller than the difference between the thermal expansion coefficient of the substrate and the thermal expansion coefficient of the first insulating film.

2. The laminated structure according to claim 1, wherein
a thickness of the second insulating film is greater than a thickness of the first insulating film at the corner portion formed at the boundary between the first surface and the second surface.

3. A laminated structure comprising:
a substrate having a first surface;
a first insulating film provided on a first region of the first surface of the substrate; and
a second insulating film provided on the first insulating film in the first region of the first surface of the substrate, and provided on a second region adjacent to the first region, wherein
a difference between a thermal expansion coefficient of the substrate and a thermal expansion coefficient of the second insulating film is smaller than the difference between the thermal expansion coefficient of the substrate and the thermal expansion coefficient of the first insulating film.

4. The laminated structure according to claim 3, further comprising:
a gap existing between the substrate and the second insulating film in the second region.

5. The laminated structure according to claim 1, wherein
the substrate is a metal, and
the first insulating film is a metal oxide.

6. The laminated structure according to claim 1, wherein
the substrate is aluminum, and
the first insulating film is aluminum oxide.

7. The laminated structure according to claim 1, wherein
the second insulating film includes an organic material.

8. The laminated structure according to claim 1, wherein
the second insulating film includes polybenzimidazole.

9. A manufacturing method for a laminated structure comprising:
using a substrate having a first surface and a second surface provided continuously with the first surface;
forming a first insulating film on the first surface and the second surface; and
forming a second insulating film by melting and spraying an organic material on the first insulating film and in a gap of the first insulating film.

10. The manufacturing method for a laminated structure according to claim 9, wherein
the substrate is a metal, and
the first insulating film is formed by anodic oxidation.

11. The manufacturing method for a laminated structure according to claim 9, wherein
the first insulating film is formed by thermal spraying.

12. The manufacturing method for a laminated structure according to claim 10, wherein
the first insulating film is a metal oxide.

13. The manufacturing method for a laminated structure according to claim 9, wherein
a thickness of the second insulating film is greater than a thickness of the first insulating film at a corner portion formed by the first surface and the second surface.

14. The manufacturing method for a laminated structure according to claim 13, wherein
the second insulating film includes a resin material.

15. The manufacturing method for a laminated structure according to claim 13, wherein
the second insulating film is polybenzimidazole.

16. The manufacturing method for a laminated structure according to any one of claims 9 to 14, further comprising:
heating the first insulating film after forming the first insulating film along the first surface and the second surface.
